# EUROPEAN PATENT APPLICATION

(11) **EP 1 575 096 A1**
(43) Date of publication of application: **14.09.2005**
(21) Application number: 03789599.2
(22) Date of filing: 16.12.2003
(51) Int. Cl.: H01L 29/737

(54) **SEMICONDUCTOR MATERIAL FOR ELECTRONIC DEVICE AND SEMICONDUCTOR ELEMENT USING SAME**

(30) Priority: 17.12.2002 JP 2002364546
(71) Applicant: Sumitomo Chemical Company, Limited, Tokyo 104-8260 (JP)
(72) Inventor: INOUE, Akira, Abiko-shi, Chiba 270-1152 (JP); HATA, Masahiko, Tsuchiura-shi, Ibaraki 300-0845 (JP)
(74) Representative: Duckett, Anthony Joseph
(86) International application number: PCT/JP2003/016081
(87) International publication number: WO 2004/055902

(57) **Abstract**

In an epitaxial substrate comprising a bipolar transistor structure having a collector layer (3), base layer (4) and emitter layer (5) on a GaAs substrate (2), the base layer (4) is configured a lower base layer (41) having a required carrier concentration, an upper base layer (42), and a low carrier concentration layer (43) provided between the lower base layer (41) and the upper base layer (42) that has a ballast effect. The lower base layer (41) or the upper base layer (42) may be omitted. The higher the temperature of the low carrier concentration layer (43) portion is, the easier it is for electrons to pass therethrough, which has the effect of raising the amplification factor, thereby helping the transistor heat stability characteristics.

## Description

### Technical Field

The present invention relates to a semiconductor material for electronic device and to a semiconductor element using same.

### Background Art

Various semiconductor electronic devices are extensively employed that include, for example, a collector layer, base layer and emitter layer and utilize the characteristics of pn junctions formed between the layers. When the passage of electricity in such semiconductor electronic devices causes the device to heat up, characteristics changes occur that adversely affect circuit operation, such as the amplification factor decreasing even when the collector current is maintained at a prescribed value, or the collector current increasing even when the base - emitter voltage is maintained at a prescribed value. Such changes in electrical characteristics based on heat factors are a general characteristic of semiconductors; conventionally, a configuration is generally used wherein the structure of the semiconductor electronic device itself is kept as it is, and fluctuations in amplification factor or collector current caused by heat changes are suppressed by adding external circuitry (Unexamined Patent Application Publication No. Hei 6-267867).

However, a configuration that is used to compensate for changes in the electrical characteristics of semiconductor electronic devices that are based on heat factors by the provision of external circuitry, is made larger by the size of the external circuitry, which makes it difficult to reduce the size of an electronic apparatus using it. Also, there are also problems in cases in which the operation of a semiconductor electronic device is thermally stabilized by the addition of external circuitry, it may not be possible to obtain a satisfactory outcome, such as in cases in which it is difficult to ensure the desired operating characteristics over a wide operational range.

An object of the present invention is to provide an electronic device semiconductor material, and a semiconductor device using same, that can resolve the above problems of the prior art.

An object of the present invention is to provide an electronic device semiconductor material that can be used to manufacture an electronic device having electrical characteristics with outstanding heat stability, and a semiconductor device using same.

### Disclosure of the Invention

In order to resolve the above problems, as the result of various experiments and repeated studies, the present inventors discovered that the temperature dependence of the current amplification factor can be kept low by forming a low carrier density layer in the base layer of a bipolar transistor, and accomplished the present invention based on this knowledge.

In an electronic device semiconductor material having a bipolar transistor structure with a collector layer, base layer and emitter layer, a characterizing feature of the present invention is that the base layer comprises a first layer having a required carrier density, and a second layer having a carrier density that is lower than the carrier density of the first layer. It is desirable for the thickness of the second layer to be not more than 1000 Å.

Another characterizing feature of the present invention is that, in an electronic device semiconductor material having a bipolar transistor structure in which a collector layer, base layer and emitter layer are formed on a semiconductor substrate, the base layer includes a first layer having a required carrier density, and a second layer having a carrier density that is lower than the carrier density of the first layer. Each of the layers provided on the semiconductor substrate can be formed as a thin-film layer. Also, the semiconductor substrate can be a GaAs substrate or an InP substrate. Moreover, a configuration can be used in which different materials are used to form the emitter layer and base layer, forming a hetero-junction.

Semiconductor devices having good characteristics with a current amplification factor having a lower temperature dependency than before can be obtained by using the above-described semiconductor material to fabricate various semiconductor devices.

### Brief Description of Drawings

Figure 1 is a diagram showing the layer structure of an embodiment of the semiconductor material according to the present invention.
Figure 2 is a graph showing the results of measurements of the temperature dependency of the HBT current amplification factor of examples of the present invention and a comparative example.
Figure 3 is a diagram showing the configuration of a HBT fabricated using the epitaxial substrate having the configuration shown in Figure 1.

### Best Mode for Carrying out the Invention

The present invention will now be described in further detail, with reference to the attached drawings.

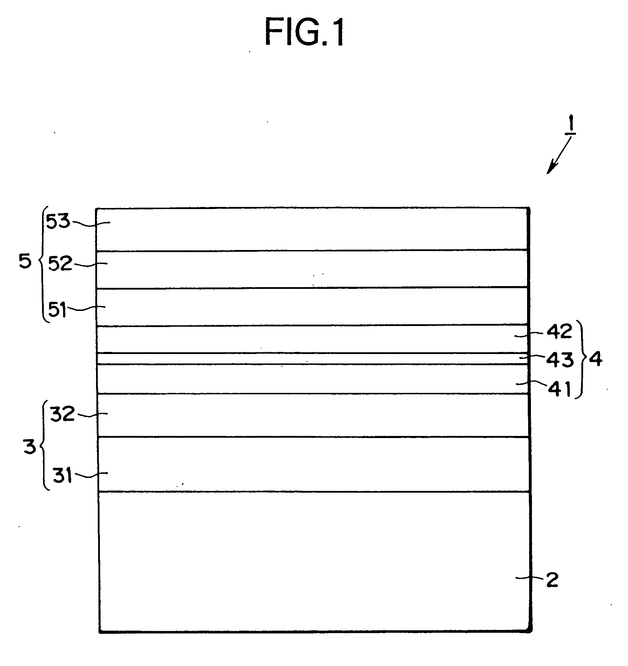

Figure 1 is a diagram showing the layer structure of an embodiment of the semiconductor material according to the present invention. In this embodiment, semiconductor material 1 is an example of an epitaxial substrate for manufacturing a hetero-junction bipolar transistor (HBT); a collector layer 3 is formed on a semiconductive GaAs substrate 2. The collector layer 3 comprises an n⁺ -GaAs layer 31 having a carrier concentration of approximately 10¹⁸cm⁻³, and a non-doped GaAs layer 32 formed as shown. The n⁺ -GaAs layer 31 is in contact with the semiconductive GaAs substrate 2.

A base layer 4 is formed on the collector layer 3. The base layer 4 comprises a lower base layer 41 and an upper base layer 42 having the required carrier concentration to function as a base layer, and a low carrier concentration layer 43 provided between the lower base layer 41 and the upper base layer 42 that has a ballast effect.

In this embodiment, the lower base layer 41 and the upper base layer 42 (first layer) are each formed as a p⁺ -GaAs layer, each of which has an ordinary carrier concentration 1 x 10¹⁹ ~ 1 x 10²⁰cm⁻³. The low carrier concentration layer 43 (second layer) is fabricated as a GaAs layer with no dopant having an ordinary carrier concentration less than 1 x 10¹⁵cm⁻³ and a thickness of 200 Å. However, the low carrier concentration layer 43 is not limited to that thickness, and may be given a thickness in the range 50 Å ~ 1000 Å.

The low carrier concentration layer 43 is fabricated as a p-type semiconductor layer having a lower carrier concentration than that of the lower base layer 41 and upper base layer 42 constituted by the other portion of the base (the first layer). In semiconductors having p-type carriers, when the carrier concentration is low, the band energy is reduced. It is surmised that adding a low band energy layer produces the improvement in temperature characteristics of this invention, as described below. Therefore, since the carrier concentration of the lower base layer 41 and upper base layer 42 constituting the other portion of the base layer is approximately 4 x 10¹⁹cm⁻³, it was considered that the effect that is the object of the present invention could be attained if the carrier concentration of the low carrier concentration layer 43 were not more than 10¹⁸cm⁻³, which is one order lower than the carrier concentration of the lower base layer 41 and upper base layer 42. In this case, also, even in the case of semiconductor having n-type carriers, the band will be lower than the portion, and it can be expected that the effect will be the same as in the case of a p-type low carrier concentration layer.

An emitter layer 5 is formed on the base layer 4. The emitter layer 5 comprises an n - InGaP layer 51 having a carrier concentration on the order of 10¹⁷cm⁻³, an n⁺ -GaAs layer 52 having a carrier concentration on the order of 10¹⁷cm⁻³, and an n⁺ -GaAs layer 53 having a carrier concentration on the order of 10¹⁸cm⁻³, laminated as shown in Figure 1.

The collector layer 3, base layer 4 and emitter layer 5 provided on the GaAs substrate 2, as described above, may be formed as thin-film layers using suitable known means. That is, the thin films of each layer may be formed using vapor phase growth by the metal-organic chemical vapor deposition method (MOCVD method), the molecular beam epitaxy method (MBE method) or other such suitable chemical vapor deposition method, or may instead be formed by the ion implantation method. As the single crystal substrate, in addition to a GaAs substrate, an InP substrate may of course be used.

As will be understood from the above explanation, in this embodiment, the material of the base layer 4 and the material of the emitter layer 5 are different, whereby the base layer 4 and emitter layer 5 form a hetero-junction, forming a hetero-junction transistor (HBT) structure on the GaAs substrate 2 having a collector layer 3, base layer 4 and emitter layer 5.

Also, this embodiment uses a configuration in which the low carrier concentration layer 43 is provided between the lower base layer 41 in contact with the non-doped GaAs layer 32 and the upper base layer 42 in contact with the n - InGaP layer 51. However, the invention is not limited to this three-layer structure. For example, the lower base layer 41 or the upper base layer 42 may be omitted.

In a HBT structure having a collector layer, base layer and emitter layer, by providing the base layer with a low carrier concentration layer, for example, as shown in Figure 1, using a base layer 4 comprising a lower base layer 41 and upper base layer 42 constituting the layers having a required carrier concentration, and a low carrier concentration layer 43 constituting a layer having a carrier concentration lower than the carrier concentration of those layers, the temperature dependency of the current amplification factor (β), that is, changes in the β temperature characteristics, is considerably improved compared to cases in which a low carrier concentration layer 43 is not provided.

When there is a junction between semiconductors having different p-type carrier concentrations, the band energy of the one with the lower carrier concentration decreases. Therefore, it is considered that as the band energy of the low carrier concentration layer 43 is lower than that of the other portion of the base layer 4 constituted by the lower base layer 41 and the upper base layer 42, electrons accumulate more readily. When the temperature is elevated, the electrons accumulated in the low carrier concentration layer 43 receive energy from the heat and readily flow from the low carrier concentration layer 43. Thus, the residency of electrons in the low carrier concentration layer 43 is reduced.

From the above, electrons pass more readily through the low carrier concentration layer 43 portion when the temperature is higher. Also, it is generally known that in the case of a HBT, a higher amplification factor can be obtained when the time that passing electrons are in the base layer is short. Therefore, the low carrier concentration layer 43 has the effect of increasing the amplification factor when the temperature increases. It can be surmised that inserting a layer having this effect of increasing the amplification factor as the temperature is elevated will have a ballast effect that ameliorates the decrease in the amplification factor caused by temperature elevation, enabling improved temperature characteristics to be achieved.

Therefore, the layer thickness and carrier concentration of the low carrier concentration layer 43 can be set to appropriately to values, providing they are within the range in which the above ballast effect of the low carrier concentration layer 43 can be obtained. The carrier dopant of the low carrier concentration layer 43 may have either p-type or n-type polarity.

### (Example 1)

An epitaxial substrate for manufacturing the HBT having the configuration shown in Figure 1 was fabricated as follows. Here, the low carrier concentration layer 43 was fabricated to have a thickness of 200 Å.

A GaAs semiconductive substrate 2 was put into a MOCVD thin-film fabrication apparatus, and a collector layer 3 comprised of an n⁺ -GaAs layer (carrier concentration of approximately 3 x 10¹⁸cm⁻³) and a non-doped GaAs layer was formed on the GaAs substrate 2, using AsH₃ gas and a metal-organic chemical compound as the materials. As the n-type dopant, Si was introduced in the form of di-silane gas to form n-type GaAs.

Next, base layer 4 was formed on the collector layer 3. The base layer 4 was divided into three layers, which were formed in the order of a lower base layer 41 formed from the side in contact with the non-doped GaAs layer 32 of the collector layer 3, a low carrier concentration layer 43 as a base ballast layer, and an upper base layer 42. The lower base layer 41, low carrier concentration layer 43 and upper base layer 42 were formed as a p⁺ -GaAs layer (carrier concentration of approximately 4 x 10¹⁹cm⁻³), a low carrier concentration GaAs layer, and a p⁺ -GaAs layer (carrier concentration of approximately 4 x 10¹⁹cm⁻³), respectively. Carbon was used as the p-type dopant. The thickness of the low carrier concentration layer 43 was set at approximately 200 Å, and in this example, the low carrier concentration GaAs layer was grown without a supply of dopant gas.

The emitter layer 5 was formed on the base layer 4. First, an n - InGaP layer 51 formed in contact with the upper base layer 42 was grown as an n - InGaP layer (carrier concentration of approximately 3 x 10¹⁷cm⁻³) using PH₃ and an organic-metal chemical compound as the materials. On that were formed, in order, the n⁺ -GaAs layer 52 and the n⁺ -GaAs layer 53, formed by growing an n - GaAs layer (carrier concentration of approximately 3 x 10¹⁷cm⁻³) and an n⁺ -GaAs layer (carrier concentration of approximately 3 x 10¹⁸cm⁻³) using AsH₃ and an organic-metal chemical compound as the materials. The emitter layer 5 described above was formed using di-silane gas as the n-type dopant, as in the case of the collector layer 3. The epitaxial substrate for manufacturing a HBT having base ballast thus fabricated was used to fabricate an HBT and the effect thereof was confirmed.

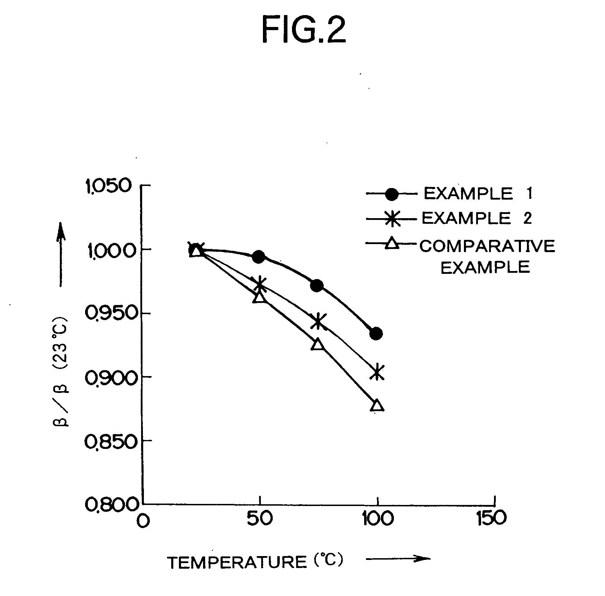

The HBT using this epitaxial substrate was manufactured as described below, and the temperature dependency of the current amplification factor (β) of the manufactured HBT was measured. The measurement results are shown as a graph in Figure 2. The vertical axis is the value of the current amplification factor (β) of the HBT, measured at different temperatures, divided by current amplification factor ((β (23°C)) at 23°C.

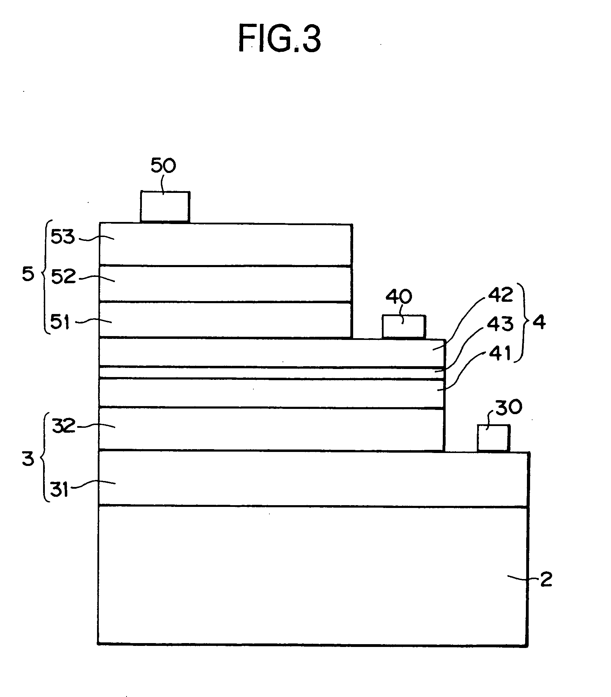

Figure 3 is a diagram showing the configuration of a HBT fabricated using the epitaxial substrate having the above-described configuration. The HBT shown in Figure 3 was fabricated by etching the epitaxial substrate, using a resist as a mask, to partially expose the n⁺ -GaAs layer 31 that functions as a sub-collector, and the upper base layer 42 that functions as a base. A collector electrode 30 and a base electrode 40 having ohmic contact are deposited on the exposed n⁺ -GaAs layer 31 and upper base layer 42, respectively, and an emitter electrode 50 was deposited on the n⁺ -GaAs layer 53 that functions as a sub-emitter, forming the bipolar transistor. A prober was used to measure the transistor characteristics.

### (Example 2)

A HBT was fabricated, using an epitaxial substrate fabricated in the same way as in the case of Example 1, except that the thickness of the low carrier concentration layer 43 was 100 Å, and the temperature dependency of the current amplification factor of the fabricated HBT was measured. The measurement results are shown as a graph in Figure 2.

### (Comparative Example)

With reference to Figure 1, a HBT was fabricated, using an epitaxial substrate fabricated in the same way as in the case of Example 1, except that it was not provided with a low carrier concentration layer 43, and the temperature dependency of the current amplification factor of the fabricated HBT was measured. The measurement results are shown as a graph in Figure 2.

From the graph shown in Figure 2, it can be seen that compared to a conventional HBT having no low carrier concentration layer 43, a HBT provided with a low carrier concentration layer 43 has improved temperature stability at the maximum current amplification factor value βmax. Also, comparing the layer thicknesses of 200 Å and 100 Å base of the low carrier concentration layer 43, it can also be seen that, the temperature stability is further improved in the case of a layer thickness of 200 Å.

Explained in further detail, as can be seen from the graph of Figure 2 showing the results of measurements of the temperature characteristics of the HBT amplification factor (β) in respect of the Examples 1 and 2 and the Comparative Example, compared to the Comparative Example, a low carrier concentration layer 43 having a thickness of 100 Å manifests an effect that sufficiently reduces the β temperature dependency. The effect is further increased by giving the low carrier concentration layer 43 a thickness of 200 Å. Therefore, it can be understood that the effect of reducing changes in the β temperature characteristics can be obtained from a case in which the thickness of the low carrier concentration layer 43 is thinner than 100 Å up to when it is thicker than 200 Å. The thicker the low carrier concentration layer 43 is, the greater the effect. However, when the thickness of the low carrier concentration layer 43 is 1000 Å or more, it becomes difficult for the electrons trapped in that portion to get out, reducing β, so that the effect becomes insufficient to reduce changes in the β temperature characteristics, making it impossible to obtain the expected effect. Also, from the point of layer thickness control, reducing the thickness of the low carrier concentration layer 43 to 50 Å or less is not realistic, in addition to which the effect of reducing the β temperature dependency is reduced, making it impossible to achieve the object of the invention. From the above, in order to obtain the object effect, the thickness range for the low carrier concentration layer 43 is 50 Å ~ 1000 Å.

The present invention is not limited to the above-described embodiment. That is, the invention is not limited to being applied only to a HBT. In the case of a homojunction bipolar transistor, too, the device can be given reduced-temperature-dependency transistor characteristics be including a low carrier concentration layer in the base layer structure, as described in the foregoing.

In accordance with the present invention, transistor heat stability characteristics can be ensured by providing a low carrier concentration layer in the base layer of various types of bipolar transistor structure, making it possible to provide semiconductor material that is useful for manufacturing various electronic devices having good temperature characteristics. Using this semiconductor material to fabricate bipolar transistors makes it possible to suppress changes in characteristics caused by heat produced by electric current during operation, enabling bipolar transistors to be obtained that perform stably with respect to temperature changes.

### Industrial Applicability

The electronic device semiconductor material and semiconductor devices using same, according to the present invention, are useful for manufacturing various electronic devices having electrical characteristics with low temperature dependency.

## Claims

1. A semiconductor material having a bipolar transistor structure with a collector layer, base layer and emitter layer, **characterized in that** the base layer comprises a first layer having a required carrier density, and a second layer having a carrier density that is lower than the carrier density of the first layer.

2. The semiconductor material according to claim 1, wherein the thickness of the second layer is not more than 1000 Å.

3. A semiconductor material having a bipolar transistor structure in which a collector layer, base layer and emitter layer are formed on a semiconductor substrate, **characterized in that** the base layer comprises a first layer having a required carrier density, and a second layer having a carrier density that is lower than the carrier density of the first layer.

4. The semiconductor material according to claim 3, wherein each of the layers provided on the semiconductor substrate is formed as a thin-film layer.

5. The semiconductor material according to claim 3, wherein the semiconductor substrate is a GaAs substrate or an InP substrate.

6. The semiconductor material according to claim 4, wherein different materials are used to form the emitter layer and base layer, forming a hetero-junction.

7. A semiconductor device manufactured using the semiconductor material according to any of claims 1 to 6.
